# EUROPÄISCHE PATENTANMELDUNG

(11) **EP 1 517 365 A2**
(43) Veröffentlichungstag der Anmeldung: **23.03.2005**
(21) Anmeldenummer: 04022113.7
(22) Anmeldetag: 17.09.2004
(51) Int. Cl.: H01L 21/762

(54) **Verfahren zur Herstellung eines Halbleiterbauelements mit aktiven Bereichen, die durch Isolationsstrukturen voneinander getrennt sind**

(30) Priorität: 19.09.2003 DE 10345346
(71) Anmelder: ATMEL Germany GmbH, 74072 Heilbronn (DE)
(72) Erfinder: Dudek, Volker, Dr., 74336 Brackenheim (DE); Graf, Michael, Dr., 71397 Leutenbach (DE)

(57) **Zusammenfassung**

Vorgestellt wird ein Verfahren zur Herstellung eines Halbleiterbauelements, das aktive Bereiche und die aktiven Bereiche trennende Isolationsstrukturen in Form von flachen und tiefen Gräben aufweist. Das Verfahren zeichnet sich dadurch aus, dass die flachen Gräben vor den tiefen Gräben erzeugt werden, dass die tiefen Gräben so angeordnet werden, dass sie innerhalb der flachen Gräben verlaufen und dass ein vollständiges Eintreiben von Dotierungsatomen zur Erzeugung von Wannen in dem Halbleiterbauelement frühestens nach dem Erzeugen der tiefen Gräben stattfindet.

## Beschreibung

Die Erfindung betrifft Verfahren zur Herstellung eines Halbleiterbauelements, das aktive Bereiche und die aktiven Bereiche trennende Isolationsstrukturen in Form von flachen und tiefen Gräben aufweist.

Ein solches Verfahren ist aus der US 5 504 033 bekannt.

In integrierten Schaltungen aus Halbleitermaterial werden aktive Bereiche voneinander durch sogenannten Feldbereiche getrennt. Beispiele von aktiven Bereichen sind einzelne Transistoren, die in das gleiche Substrat integriert sind. Um eine unerwünschte Drift von Ladungsträgern wie Elektronen oder Löchern zwischen den aktiven Bereichen zu vermeiden, werden die Feldbereiche mit isolierenden Strukturen versehen. Bei auf der Siliziumtechnologie basierenden integrierten Schaltungen ist es bekannt, aktive Bereiche an der Oberfläche der Schaltung durch eine aus Siliziumoxid bestehende, meist Feldoxid genannte Isolationsstruktur zu isolieren.

Die Isolationsstruktur wird zum Beispiel mit Hilfe der LOCOS-Technologie hergestellt. Bei der LOCOS-Technologie (local oxidation of silicon) werden zunächst die aktiven Bereiche der Schaltung durch eine strukturierte Siliziumnitridschicht abgedeckt. Anschließend wird die gesamte Oberfläche oxidiert. Da die Konversionsrate von Siliziumnitrid in Siliziumdioxid nur etwa 1 % der Wachstumsrate des Oxides auf den nicht abgedeckten Feldbereichen der integrierten Schaltung beträgt, wächst die Isolationsstruktur aus Siliziumoxid bevorzugt in den Feldgebieten zwischen den aktiven Bereichen der integrierten Schaltung. Ein Problem bei der LOCOS-Technologie besteht in einer Vogelschnabel-artigen Verjüngung der Oxidschicht an den Rändern der Nitridschicht. Diese Schnabelstruktur entsteht als Folge einer von den Rändern der Nitridschicht her erfolgenden Eindiffusion oxidierender Gase unter die Nitridschicht. Nach dem Entfernen der Nitridschicht ergibt sich als Folge ein gradueller Übergang vom Feldoxid zum aktiven Bereich. Breite und Form der Schnabelstruktur bestimmen den Mindestabstand benachbarter aktiver Gebiete und damit die erreichbare Packungsdichte der aktiven Bereiche in der integrierten Schaltung.

Eine weitere Möglichkeit zur Isolierung aktiver Bereiche wird durch die sogenannte STI-Technologie bereitgestellt. Bei der "shallow trench isolation"-Technologie werden durch einen anisotropen Ätzprozess Gräben zwischen den mit einer Nitridschutzschicht bedeckten aktiven Bereichen erzeugt und mit einem isolierenden Material wie Siliziumdioxid oder Polysilizium aufgefüllt. Dabei gilt ein Graben bei einem Aspekt-Verhältnis, also einem Verhältnis von Grabentiefe zu Grabenbreite, das kleiner als 1 ist, als flach im Sinne der namensgebenden Beschreibung. Mit der STI-Technologie lassen sich im Vergleich zur LOCOS-Technologie höhere Packungsdichten erzielen.

Für eine Isolierung aktiver Bereiche in der Tiefe der Struktur der integrierten Schaltung werden sogenannte tiefe Gräben (deep trenches) und/oder sogenannte Wannen für die laterale Isolierung verwendet. Ein tiefer Graben zeichnet sich durch ein Aspekt-Verhältnis aus, das größer als 1 ist (der Graben ist tiefer als er breit ist). Eine Wanne ist ein dreidimensionaler Teilbereich der Halbleiterstruktur, dessen Majoritätsladungsträger von einem anderen Typ (z.B. p) sind als die Majoritätsladungsträger in der Umgebung der Wanne (z.B. n). Als Folge bilden sich an den Grenzen der Wannen bei entsprechender Polung sperrende pn-Übergänge aus, die das Innere der Wanne elektrisch von ihrer Umgebung isolieren.

Die Wannen werden in der Regel durch Implantieren eines Dotierstoffes und thermisch unterstütztes Eindiffundieren des Dotierstoffes erzeugt. Da sich bei der Eindiffusion in der Regel keine Vorzugsrichtung ausbildet, findet die Eindiffusion sowohl in die Tiefe als auch in die Breite statt. Je tiefer die Wannen in Hochtemperaturschritten in das Halbleitersubstrat, beispielsweise Silizium, eingetrieben werden (Wannen-Drive), desto größer ist die laterale Ausdehnung der Wannen und deren gegenseitige elektrische Beeinflussung. Um diese elektrische Beeinflussung auszuschließen, müssen die Abstände elektrisch aktiver Gebiete mit unterschiedlichen Wannendotierungen entsprechend groß gewählt werden. Eine gewünschte Tiefe erfordert damit immer auch eine gewisse Breite, was letztlich zu unerwünschten Beschränkungen der Packungsdichte führt. Ähnliche Beschränkungen ergeben sich analog bei hohen Dotierstoffkonzentrationen.

Vor diesem Hintergrund besteht die Aufgabe der Erfindung in der Angabe eines Verfahrens zur Herstellung von integrierten Schaltungen mit voneinander isolierten aktiven Bereichen, bei denen die genannten Beschränkungen aufgehoben oder zumindest verringert sind.

Diese Aufgabe wird bei einer integrierten Schaltung der eingangs genannten Art dadurch gelöst, dass die flachen Gräben vor den tiefen Gräben erzeugt werden, dass die tiefen Gräben so angeordnet werden, dass sie innerhalb der flachen Gräben verlaufen, und dass ein vollständiges Eintreiben von Dotierungsatomen durch eine thermisch unterstützte Diffusion zur Erzeugung von Wannen in dem Halbleiterbauelement frühestens nach dem Erzeugen der tiefen Gräben stattfindet.

Auf diese Weise wird die laterale Diffusion von Wannen-Dotierstoffen durch die Grabenstrukturen beschränkt. Daher können kleine Wannengebiete mit hohen und/oder tief in ein Volumen des Halbleitersubstrates hinabreichenden Dotierstoffkonzentrationen erzeugt werden, ohne dass an den Rändern der Wannen eine unerwünschte laterale Diffusion auftritt. Eine solche unerwünschte laterale Diffusion wird durch die Gräben verhindert. Die flachen Gräben sorgen aufgrund ihrer vergleichsweise großen Breite für eine gute Isolierung der aktiven Bereiche an der Oberfläche.

Wenn die tiefen Gräben vor Hochtemperaturschritten eines Wannen-Drives geätzt werden, besteht grundsätzlich das Problem, das wegen der hohen thermischen Belastung am Rand der Grabenisolation Defekte auftreten können, die später zu hohen, unerwünschten Leckströmen führen. Es hat sich gezeigt, dass die erfindungsgemäße Vorgehensweise, nach der die tiefen Gräben innerhalb der flachen Gräben verlaufen und nach den flachen Gräben erzeugt werden, zu einer signifikanten Verminderung dieses Problems führt. Möglicherweise wird dieses Problem durch den Wegfall einer hohen Topografiestufe verringert, wie sie bei tiefen Gräben auftritt, die nicht innerhalb von flachen Gräben verlaufen.

Die Merkmale der zeitlichen Reihenfolge und der Topologie stehen damit in einer Wechselwirkung miteinander. Es ist diese zeitliche Reihenfolge der Grabenerzeugung und die spezifische Topologie und Topografie der Grabenverläufe, die einen Wannen-Drive durch Hochtemperaturschritte zeitlich nach einem Erzeugen tiefer Gräben mit verringertem Auftreten unerwünschter Leckströme möglich macht.

Es ist bevorzugt, dass die Eindiffusion der Dotierungsatome so gesteuert wird, dass die Wannen wenigstens teilweise durch die tiefen Gräben und/oder die flachen Gräben begrenzt werden.

Als Folge dieser Maßnahme werden laterale Grenzen einer Wanne nicht mehr durch eine nur ungenau vorhersehbare Querdiffusion bestimmt. Vielmehr kann die Grenze exakt durch den Verlauf der Gräben vorgegeben werden. Als Folge kann eine Waferfläche, also beispielsweise die Fläche einer Siliziumscheibe, besser ausgenutzt werden. Insbesondere ergibt sich die Möglichkeit, den lateralen Abstand verschiedener aktiver Gebiete in verschieden dotierten Wannen unabhängig von der jeweiligen Dotierstoffkonzentration und der Tiefe der Wannen einzustellen.

Bevorzugt ist auch, dass die tiefen Gräben so erzeugt werden, dass ihre Tiefe mindestens so groß ist wie die Tiefe der Wannen.

Durch diese Maßnahme können die Wannen nicht nur an der Oberfläche, sondern auch im Volumen des Halbleitersubstrates definiert voneinander getrennt werden.

Ferner ist bevorzugt, dass die tiefen Gräben und die Wannen bei einem Halbleiterbauelement mit einem Siliziumvolumen auf einer Isolatorschicht bis zur Isolatorschicht hinunterreichen.

Durch diese Maßnahme wird eine perfekte Isolierung aktiver Bereiche zur Seite und nach unten erzielt. Das Ausdehnen der Wannen bis hinunter auf eine isolierende Zwischenschicht eines SOI-Wafers liefert in Verbindung mit der geringen Dicke des Halbleitersubstrates den Vorteil, dass parasitäre Kapazitäten unterdrückt werden.

Eine weitere bevorzugte Ausgestaltung zeichnet sich dadurch aus, dass die flachen Gräben durch einen STI-Prozess erzeugt werden.

Diese Maßnahme hat gegenüber einer Isolierung durch eine LOCOS-Technologie den Vorteil, dass keine durch Unterdiffusion hervorgerufenen Vogelschnabelstrukturen an den Rändern des Feldoxids auftreten, die zu einem Flächenverlust führen. Als Folge ermöglicht die STI-Technik eine höhere Bauelement-Packungsdichte durch kleinere Verlustflächen.

Bevorzugt ist auch, dass die flachen Gräben und die tiefen Gräben gemeinsam mit einer Isolierung versehen werden, die zum Beispiel durch Füllen der Gräben mit einem Oxid oder mit Polysilizium erzeugt wird.

Durch das gemeinsam erfolgende Auffüllen können Maskenschritte, die bei einem getrennten Auffüllen möglich wären, entfallen. Als Folge ergeben sich Rationalisierungsvorteile bei der Fertigung.

Eine weitere bevorzugte Ausgestaltung zeichnet sich dadurch aus, dass Wände der Gräben vor dem Auffüllen der Gräben mit Lineroxiden versehen werden. Dabei wird unter einem Lineroxid eine dünne Oxidschicht verstanden.

Die Lineroxide besitzen einerseits den Vorteil, zu einem Abrunden von Kanten der Grabenstrukturen beizutragen und damit eine stabile Schnittstelle zwischen dem Halbleitersubstrat und den Grabenstrukturen bereitzustellen. Diese Eigenschaft hätten dickere Oxide auch. Der besondere, zusätzliche Vorteil der dünnen Lineroxide besteht darin, dass sie so dünn sind, dass keine durch mechanische Spannungen erzeugten Defektlinien erzeugt werden, die später zu hohen Leckströmen führen könnten.

Bevorzugt ist auch, dass die Dotierungsatome durch Ionenimplantation eingebracht werden und erst später durch eine thermisch unterstützte Diffusion vollständig eingetrieben werden.

Das Einbringen der Dotierungsatome durch eine Ionenimplantation ist eine erprobte und gebräuchliche Technik mit der definierte Dotierstoffkonzentrationen mit reproduzierbar hoher Genauigkeit eingebracht werden können. Das zeitliche Trennen von Implantieren und vollständigem Eintreiben ermöglicht die Zwischenschaltung der oben genannten Schritte zur Grabenbildung.

Eine bevorzugte Prozessschrittfolge weist die folgenden Schritte auf: Definieren von Wannenbereichen durch Aufbringen einer strukturierten Hartmaske, Implantieren von Dotierstoffatomen verschiedener Polarität in verschiedenen, aneinander angrenzenden Bereichen, wobei in einen einzelnen Bereich jeweils ein Dotierstoff einer Polarität implantiert wird, Erzeugen von flachen Gräben zwischen Wannenbereichen verschiedener Polarität, Erzeugen tiefer Gräben, die innerhalb der flachen Gräben verlaufen, Erzeugen von dünnen Oxidschichten auf Oberflächen der Gräben, Eintreiben der implantierten Dotierstoffe durch einen thermisch unterstützten Diffusionsprozess, und Füllen der Gräben.

Diese Kombination stellt ein Ausführungsbeispiel dar, das die meisten der oben genannten Vorteile kumuliert. Dabei ist die Aufzählung nicht abschließend gemeint. Es können beispielsweise vor, zwischen oder nach den genannten Schritten Maskenschritte und/oder Reinigungsschritte vorgesehen sein.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in der Form schematischer Querschnitte:
- Fig. 1: ein Halbleitersubstrat im Querschnitt während einer Implantation eines ersten Dotierstoffs zur Definition einer ersten Wanne;
- Fig. 2: das Halbleitersubstrat während einer Implantation eines zweiten Dotierstoffs zur Definition einer zweiten Wanne;
- Fig. 3: das Halbleitersubstrat nach einer STI-Ätzung;
- Fig. 4: das Halbleitersubstrat nach einer deep trench Ätzung;
- Fig. 5: das Halbleitersubstrat nach der Erzeugung von Lineroxiden;
- Fig. 6: das Halbleitersubstrat nach einem Eintreiben der Dotierstoffe durch eine thermisch unterstützte Diffusion; und
- Fig. 7: das Halbleitersubstrat nach einem Auffüllen der Gräben mit einem isolierenden Material.

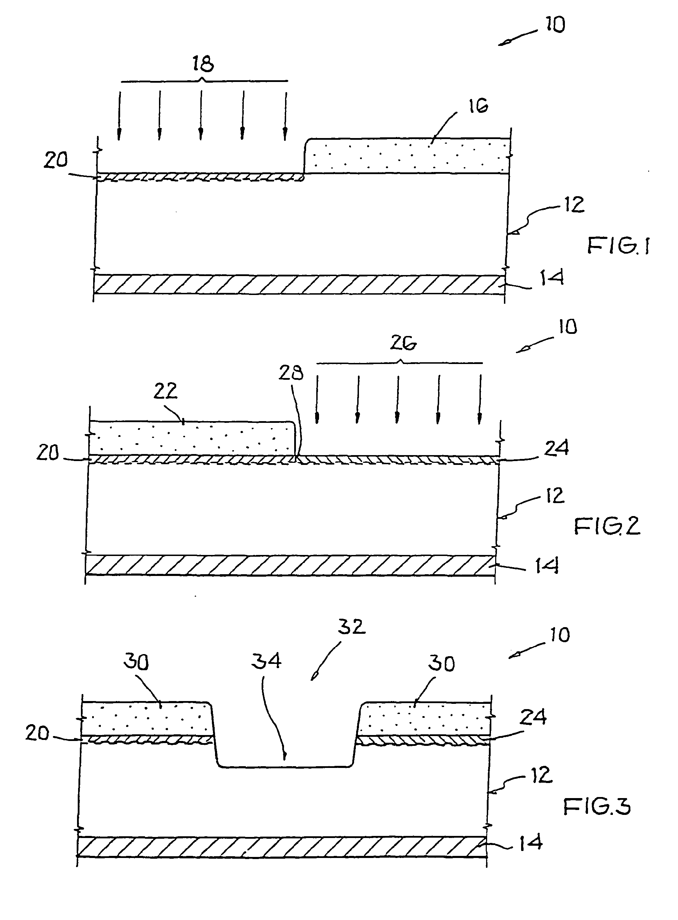

Die Figur 1 zeigt einen Teilquerschnitt eines Halbleiterkörpers 10, der ein halbleitendes Substrat 12 auf einer isolierenden Zwischenschicht 14 aufweist. Ein typisches Beispiel eines solchen Halbleiterkörpers 10 wird durch einen "silicon on insulator"-Wafer (SOI)-Wafer repräsentiert. Dabei wird die isolierende Zwischenschicht 14 in der Regel als Siliziumdioxid-Schicht realisiert sein. Zur Erzeugung von Wannen mit unterschiedlicher Leitfähigkeit der jeweiligen Majoritätsladungsträger werden Teilbereiche des halbleitenden Substrates 12 mit Dotierstoffen unterschiedlicher Wertigkeit dotiert, so dass sich in ihnen unterschiedliche Leitfähigkeitstypen einstellen.

Für eine P-Leitfähigkeit wird beispielsweise ein vierwertiges Halbleitersubstrat wie Silizium mit Bor-Atomen dotiert, die im Siliziumgitter als dreiwertige Substitutionsstörstellen eingebaut werden und als Elektronen-Akzeptoren wirken. Analog wird eine N-Leitfähigkeit durch Dotieren eines beispielsweise vierwertigen Halbleitersubstrates mit Arsen oder Phosphor erzeugt, die als fünfwertige Substitutionsstörstellen in das aus vierwertigen Siliziumatomen aufgebaute Grundgitter eingebaut werden und als Elektronen-Donatoren wirken.

Zur Definition der Wannengebiete werden Bereiche, die nicht dotiert werden sollen, durch eine Maske abgedeckt. Das Einbringen der Dotierstoffe in die nicht durch die Maske 16 abgedeckten Bereiche kann prinzipiell nach einer Diffusionstechnik oder mit einer Ionenstrahlimplantation erfolgen. In der Regel wird bei modernen Herstellungsverfahren die Ionenstrahlimplantation bevorzugt, bei der eine genau kontrollierte Menge an Dotieratomen zunächst einheitlich ionisiert und auf eine definierte Ionengeschwindigkeit gebracht wird. In der Fig. 1 wird ein Strahl aus solchen ionisierten Dotieratomen durch die Pfeile 18 repräsentiert.

Der Strahl 18 aus Dotier-Ionen trifft auf nicht durch die Maske 16 abgedeckte Teilbereiche des halbleitenden Substrates 12 und dringt in das Gitter ein. Dort werden die Ionen abgebremst. Die Eindringtiefe hängt von der kinetischen Energie der Ionen ab. Durch die Energieabgabe schädigen die Ionen den Kristall und kommen zunächst meist auf Zwischengitterplätzen zur Ruhe. Nach der Implantation sind deshalb Ausheil- und Aktivierungsschritte bei erhöhter Temperatur notwendig, um Schäden zu beseitigen und möglichst alle Dotieratome auf Gitterplätze zu bringen. Es ist ein wesentliches Merkmal der Erfindung, dass diese Ausheil- und Aktivierungsschritte nicht direkt auf die Implantation folgen, sondern erst nach weiteren Strukturierungsschritten durchgeführt werden.

In der Figur 1 repräsentiert die vergleichsweise dünne Schicht 20 die durch eine vorhergehende Implantation mit Dotierstoffatomen angereicherte Oberflächenschicht des Halbleitersubstrates 12. Dabei repräsentiert die von links unten nach rechts oben verlaufende Schraffur der Schicht 20 einen bestimmten Leitfähigkeitstyp der Dotierung, beispielsweise eine P-Leitfähigkeit. Die vergleichsweise große Dichte der Schraffierung repräsentiert eine hohe Dotierstoffkonzentration.

Im Anschluss an eine solche Implantation einer P-Wannen-Dotierung erfolgt in einem weiteren Maskenschritt ein Abdecken der ersten Dotierschicht 20 durch eine weitere Maske 22 und das Erzeugen einer zweiten Dotierschicht 24 einer zweiten Leitfähigkeit, beispielsweise einer N-Leitfähigkeit. Die zweite Dotierschicht 24 kann unmittelbar an die erste Dotierschicht 20 angrenzen. Auch die zweite Dotierschicht 24 wird bevorzugt nach einem Ionenimplantationsverfahren durch Beschießen der nicht durch die zweite Maske 22 abgedeckten Oberflächenbereiche des Halbleitersubstrates 12 mit Dotierstoffionen des zweiten Leitfähigkeitstyps (Strahl 26) erzeugt.

Zum Abdecken der Bereiche, die bei den verschiedenen Diffusionsschritten nicht dotiert werden sollen, eignen sich zum Beispiel dielektrische Materialien, die auch bei der Diffusionstechnik eingesetzt werden, wie Siliziumoxid und Siliziumnitrit. Die Ionenabbremsung in Festkörpern ist aber im Gegensatz zur Diffusion kein thermodynamischer, sondern im Wesentlichen ein mechanischer Prozess. Daher kann als Maskenmaterial jedes Material eingesetzt werden, das eine solche mechanische Abbremsung ermöglicht. Da bei der Ionenimplantation keine hohen Temperaturen auftreten, kann insbesondere der belichtete und entwickelte Fotolack selbst als Maskenmaterial, das heißt als Schutzschicht gegen implantierte Ionen verwendet werden. Da bei Masken 16, 22 aus Fotolack keine separaten Temperaturschritte zur Erzeugung von Schutzschichten nötig sind, wie sie etwa bei der Abscheidung von Oxiden und Nitriden erforderlich sind, wird die Scheibendurchlaufzeit und die thermische Belastung der Wafer minimiert.

Die Masken 16, 22 werden daher bevorzugt lithografisch als Fotolackschicht definiert. Durch einen Ätzschritt werden belichtete oder nicht belichtete Lackfenster bis zur Oberfläche des halbleitenden Substrates 12 freigeätzt. Anschließend erfolgt ein Belegen der freien Oberfläche des halbleitenden Substrates 12 mit einem Streuoxid und die Dotierung durch die Ionenimplantation.

Alternativ dazu wird der Halbleiterkörper 10 in einem LOCOS-Prozess zunächst mit einem feucht gebildeten Oxid überzogen, das später bei der Dotierung der Wannengebiete als Implantationsmaske dient. Die Isolationsstruktur wird zum Beispiel mit Hilfe der LOCOS-Technologie hergestellt. Die Wannenbereiche werden lithografisch mit Masken in einer Fotolackschicht definiert. Ein nasschemischer Ätzschritt öffnet das Oxid in den Lackfenstern bis zur Siliziumoberfläche. Nach einem Belegen der freien Siliziumoberfläche mit einem Streuoxid erfolgt eine Dotierung durch Ionenimplantation.

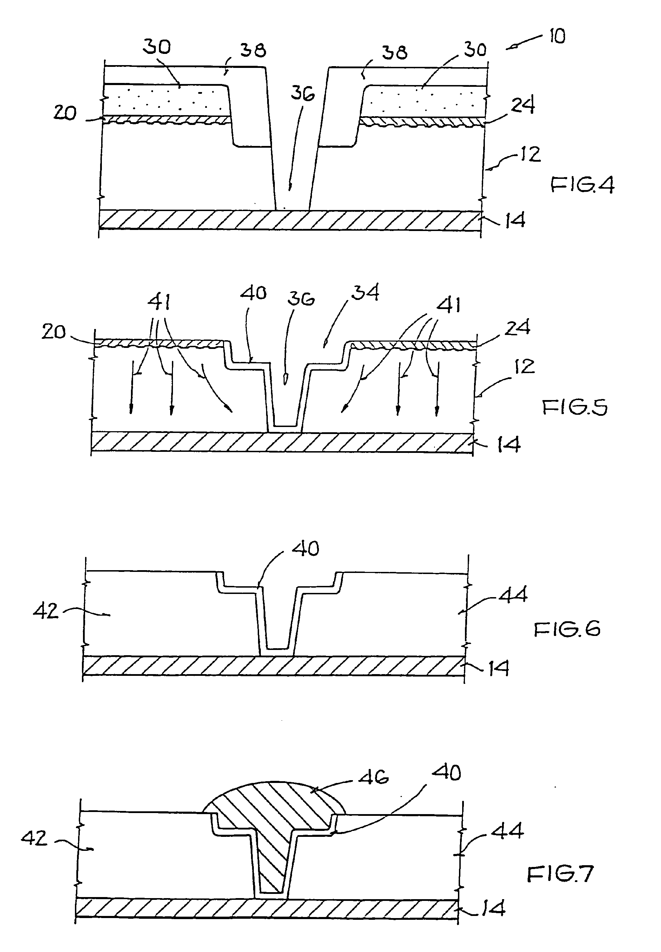

Im Anschluss an die Ionenimplantation wird über der Grenzlinie zwischen der ersten Dotierschicht 20 und der zweiten Dotierschicht 24, die in der Figur 2 als Punkt 28 sichtbar ist, eine Öffnung 32 in einer zwischenzeitlich aufgebrachten Hartmaske, die beispielsweise aus Siliziumnitrit besteht, erzeugt. Anschließend wird entlang der Grenzlinie 28 eine Grabenstruktur 34 in dem halbleitenden Substrat 12 erzeugt, was beispielsweise durch eine anisotrope STI-Ätzung (shallow trench isolation) erreicht werden kann. Bei der "shallow trench isolation"-Technologie werden durch einen anisotropen Ätzprozess Gräben zwischen den mit einer Nitritschutzschicht 30 bedeckten Bereichen erzeugt und später mit einem isolierenden Material wie Siliziumdioxid oder Polysilizium aufgefüllt.

Dabei gilt ein Graben bei einem Aspektverhältnis, also einem Verhältnis von Grabentiefe zu Grabenbreite, das kleiner eins ist, als flach im Sinne der namensgebenden Beschreibung. Der Halbleiterkörper 10 mit einem noch nicht aufgefüllten Graben 34 in dem halbleitenden Substrat 12 ist in der Figur 3 abgebildet. Durch den Graben 34 wird ein räumlicher Abstand zwischen der ersten Dotierschicht und der zweiten Dotierschicht 24 erzeugt. Darüber hinaus werden durch das Ausheben des Grabens 34 Dotierunschärfen, die sich aus einer Überlappung der Masken 16 und 22 ergeben können, beseitigt.

Anschließend erfolgt in einem weiteren Schritt, dessen Ergebnis in der Figur 4 dargestellt ist, die Erzeugung eines tiefen Grabens (deep trench) 36, der bei einem SOI-Wafer bevorzugt bis hinunter zur isolierenden Zwischenschicht 14 reicht. Zur Erzeugung des tiefen Grabens 36 wird in einem weiteren Maskenschritt die Maske 38 selbstjustierend auf der Maske 30 der STI-Ätzung aufgebracht. Wie bereits erwähnt, verläuft der tiefe Graben 36 innerhalb des flachen Grabens 34 und zwar bevorzugt in dessen Mitte. Wie bereits eingangs erwähnt wurde, verringert das innerhalb der flachen Gräben 34 erfolgende Erzeugen der tiefen Gräben 36 das Risiko einer späteren Defektstellenbildung am Rand der tiefen Gräben bei nachfolgenden Hochtemperaturschritten wesentlich.

Zusätzlich wird diese Gefahr durch die Ausbildung einer dünnen Oxidschicht, eines Lineroxides 40 auf der Oberfläche der Grabenstruktur 34, 36 verringert. Das nach dem Entfernen der Masken 30, 38 aufgebrachte Lineroxid 40 ist in der Figur 5 dargestellt.

Erst nach Fertigstellung der Grabenstrukturen 34, 36 erfolgt in einem Hochtemperaturschritt ein vollständiges Eintreiben der innerhalb der Dotierschichten 20 und 24 oberflächlich implantierten Dotierstoffe in die Tiefe des halbleitenden Substrates 12. Das Eintreiben erfolgt durch eine Diffusion der Dotierstoffatome in die Tiefe des Halbleitersubstrats 12, wobei der Diffusionsprozess durch die hohe Temperatur unterstützt wird. Die Pfeile 41 in der Figur 5 repräsentieren das Eintreiben der in den oberflächlichen Dotierschichten 20 und 24 gewissermaßen vorgelagerten Dotierstoffmenge in die Tiefe des halbleitenden Substrates 12.

Das Ergebnis dieses Hochtemperaturschrittes ist in der Figur 6 dargestellt, in der die Schraffurrichtung, wie auch bereits bei den Schraffurrichtungen der Dotierschichten 20 und 24, den resultierenden Leitfähigkeitstyp anzeigt. der die Leitfähigkeit in dem betreffenden Bereich dominiert. Im Beispiel der Figur 6 hat sich links eine P-Wanne 42 und rechts eine N-Wanne 44 durch den Diffusionsprozess gebildet. Die Dichte der Schraffur steht dabei in einem umgekehrten Verhältnis zur Konzentration der Dotierstoffatome im halbleitenden Substrat 12. Während diese Konzentration in den ursprünglichen oberflächlichen Dotierschichten 20 und 24 noch vergleichsweise groß war, hat sich die Konzentration der Dotierstoffe durch Verteilung über das ganze Volumen des halbleitenden Substrates 12 verringert. Das Eintreiben in einer Hochtemperaturphase wird bevorzugt so lange aufrechterhalten, bis sich eine gute Gleichverteilung der Dotierstoffe bis an die Grenzen der grabenförmigen Struktur 34, 36 ausgebildet hat. Durch die Diffusion der zunächst auf Zwischengitterplätze implantierten Dotierstoffatome auf reguläre Gitterplätze werden die Dotierstoffatome aktiviert. Durch diesen Vorgang und durch Platzwechselvorgänge der Atome des Wirtsgitters findet darüber hinaus ein Ausheilen der durch den Ionenbeschuss hervorgerufenen Strahlenschäden in dem Wirtsgitter statt.

In diesem Verfahrensstadium sind die beiden Wannen 42 und 44 an der Unterseite des Halbleitersubstrates 12 durch die isolierende Zwischenschicht 14 gegeneinander isoliert. In der Tiefe des halbleitenden Substrates 12 sind sie durch die Grabenstruktur 34, 36 gegeneinander isoliert. Um eine gute Isolierung auch an der Oberfläche des halbleitenden Substrates 12 zu erzielen, wird anschließend die Grabenstruktur 34, 36 mit einem dielektrischen Material, beispielsweise Siliziumdioxid oder Polysilizium aufgefüllt. Das Auffüllen durch Oxidation kann selbstverständlich bereits parallel zum Hochtemperaturschritt des vollständigen Eintreibens der Dotierstoffatome in die Tiefe des halbleitenden Substrates 12 durchgerührt werden.

Das in der Figur 7 dargestellte Ergebnis repräsentiert einen Halbleiterkörper 10, bei dem verschieden dotierte Wannenbereiche 42, 44 perfekt durch Grabenstrukturen 34, 36 gegeneinander isoliert sind. Bei entsprechendem Verlauf der Grabenstrukturen 34, 36 können dadurch beispielsweise Bauelement-Boxen in einem Wafer erzeugt werden. Die Erzeugung aktiver Bereiche innerhalb der Wannen 42, 44, beispielsweise die Erzeugung von DMOS-Transistoren, bleibt späteren Verfahrensschritten vorbehalten, die per se bekannt sind und nicht Gegenstand dieser Anmeldung sind.

Das erfindungsgemäße Verfahren kann auch zur Herstellung von Wannen in sogenannten bulk-Substraten verwendet werden. In diesem Fall, in dem die Wannen nicht bis auf eine Isolatorschicht hinunterreichen, werden die tiefen Gräben bevorzugt tiefer als die Wannentiefe ausgeätzt.

## Patentansprüche

1. Verfahren zur Herstellung eines Halbleiterbauelements (10), das aktive Bereiche und die aktiven Bereiche trennende Isolationsstrukturen in Form von flachen Gräben (34) und tiefen Gräben (36) aufweist, **dadurch gekennzeichnet, dass** die flachen Gräben (34) vor den tiefen Gräben (36) erzeugt werden, dass die tiefen Gräben (36) so angeordnet werden, dass sie innerhalb der flachen Gräben (34) verlaufen und dass ein vollständiges Eintreiben (41) von Dotierungsatomen zur Erzeugung von Wannen (42, 44) in dem Halbleiterbauelement (10) frühestens nach dem Erzeugen der tiefen Gräben (36) stattfindet.

2. Verfahren nach Anspruch 1, **dadurch gekennzeichnet dass** das Eintreiben (41) der Dotierungsatome so gesteuert wird, dass die Wannen (42, 44) wenigstens teilweise durch die tiefen Gräben (36) und/oder die flachen Gräben (34) begrenzt werden.

3. Verfahren nach Anspruch 2, **dadurch gekennzeichnet, dass** die tiefen Gräben (36) so erzeugt werden, dass ihre Tiefe mindestens so groß ist wie die Tiefe der Wannen (42, 44).

4. Verfahren nach Anspruch 3, **dadurch gekennzeichnet, dass** die tiefen Gräben (36) und die Wannen (42, 44) bei einem Halbleiterbauelement (10) mit einem Siliziumvolumen (12) auf einer Isolatorschicht (14) bis zur Isolatorschicht (14) hinunterreichen.

5. Verfahren nach wenigstens einem der vorhergehenden Ansprüche, **dadurch gekennzeichnet, dass** die flachen Gräben (34) durch einen STI-Prozess erzeugt werden.

6. Verfahren nach wenigstens einem der vorhergehenden Ansprüche, **dadurch gekennzeichnet, dass** die flachen Gräben (34) und die tiefen Gräben (36) gemeinsam mit einer Isolierung (40, 46) versehen werden.

7. Verfahren nach wenigstens einem der vorhergehenden Ansprüche, **dadurch gekennzeichnet, dass** die Gräben (34, 36) mit einem Oxid oder mit Polysilizium aufgefüllt werden.

8. Verfahren nach Anspruch 6, **dadurch gekennzeichnet, dass** Wände der Gräben (34, 36) vor dem Auffüllen der Gräben (34, 36) mit Lineroxiden (40) versehen werden.

9. Verfahren nach wenigstens einem der vorhergehenden Ansprüche, **dadurch gekennzeichnet, dass** die Dotierungsatome durch Ionenimplantation eingebracht werden und durch eine thermisch unterstützte Diffusion vollständig eingetrieben werden.

10. Verfahren nach wenigstens einem der vorhergehenden Ansprüche, **gekennzeichnet durch** folgende Prozessschrittfolge:
Definieren von Wannenbereichen **durch** Aufbringen einer strukturierten Maske (16, 18);
Implantieren von Dotierstoffatomen verschiedener Polarität in verschiedenen, aneinander angrenzenden Bereichen (20, 24), wobei in einen einzelnen Bereich (20, 24) jeweils ein Dotierstoff einer Polarität implantiert wird;
Erzeugen von flachen Gräben (34) zwischen Bereichen (20, 24) verschiedener Polarität;
Erzeugen tiefer Gräben (36), die innerhalb der flachen Gräben (34) verlaufen;
Erzeugen von dünnen Oxidschichten (40) auf Oberflächen der Gräben (34, 36);
Eintreiben (41) der implantierten Dortierstoffe **durch** einen thermisch unterstützten Diffusionsprozess; und
Füllen der Gräben (34, 36) mit isolierendem Material (36).
